Europäisches Patentamt

European Patent Office

Office européen des brevets

(19)

(11)　**EP 1 557 960 A1**

(12)　# EUROPEAN PATENT APPLICATION

(43) Date of publication:
　　**27.07.2005 Bulletin 2005/30**

(51) Int Cl.$^7$: **H04B 1/62**, H04L 25/03,
　　H03G 7/08

(21) Application number: **05001251.7**

(22) Date of filing: **21.01.2005**

(84) Designated Contracting States:
　　**AT BE BG CH CY CZ DE DK EE ES FI FR GB GR
　　HU IE IS IT LI LT LU MC NL PL PT RO SE SI SK TR**
　　Designated Extension States:
　　**AL BA HR LV MK YU**

(30) Priority: **26.01.2004 KR 2004004850**

(71) Applicant: **LG Electronics Inc.
　　Seoul, 150-721 (KR)**

(72) Inventor: **Moon, Hong Shik
　　Seocho-gu Seoul (KR)**

(74) Representative: **Sajda, Wolf E., Dipl.-Phys. et al
　　Meissner, Bolte & Partner GbR,
　　Postfach 10 26 05
　　86016 Augsburg (DE)**

(54)　**Emphasis circuit**

(57)　The present invention relates to an emphasis circuit, and more particularly to an emphasis circuit that can compensate for attenuating signals by applying an emphasis effect to the edges of a square wave input signal. An emphasis circuit according to the present invention adds an emphasis signal to a square wave to compensate for the attenuation of square wave signal, when the square wave signal including the emphasis signal is characterized by a wave form that maintains the original voltage level of the square wave after a predetermined falling time from a rising edge or after a predetermined rising time from a falling edge.

**Fig. 5**

EP 1 557 960 A1

## Description

This nonprovisional application claims priority under 35 U.S.C. § 119(a) on Patent Application No. 10-2004-0004850 filed in Korea on January 26, 2004, the entire contents of which are hereby incorporated by reference.

## BACKGROUND OF THE INVENTION

### Field of the Invention

The present invention relates to an emphasis circuit, and more particularly to an emphasis circuit that can compensate for attenuating signals by applying an emphasis effect to the edges of a square wave input signal.

### Description of the Background Art

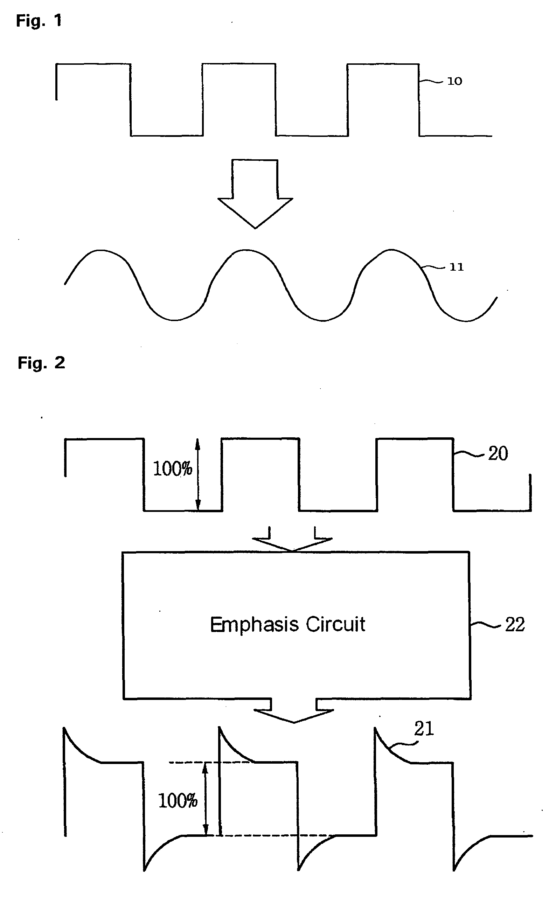

FIG. 1 shows the input and output signals through a conventional transmission line. As illustrated in FIG. 1, when a digital signal which is generally a square wave (10) and an analog signal which is similar to a square wave are transmitted through a transmission line, the sharp signal from sending end is attenuated at receiving end due to the limitation of frequencies that pass through the transmission line. In other words, a rectangular square wave signal (10) is output in the form of a gradual curve (11) that is similar to a sine wave.

In particular, for a cathode ray tube that receives analog R, G, B signals and outputs them as analog signals and a digital display device that transforms them to digital signals through an analog-to-digital converter, a square wave from sending end is transmitted to a display device through a transmission line.

This transmission signal in said display device is more fully explained as follows: First, the R, G, B signals for the display device from sending end are defined as a square wave that swings between full black and full white. Later, the display device displays the square wave signals attenuated by the transmission line, and then displays said square wave signals to which an effect is applied to maintain their sharpness. Then, when viewer look at the displayed signals, the interface between full black and full white is much sharper for viewer to which the above effect is applied. This is referred to as sharpness improvement effect in image signal processing.

However, the sharp square wave signals from sending end arrive at receiving end in an attenuated form due to the limitation of frequencies that pass through a transmission line. Therefore, the problem occurs that the square wave signals input to receiving end do not have the sharp form of a square wave but are transformed into a gradual curve similar to a sine wave.

## SUMMARY OF THE INVENTION

Accordingly, an object of the present invention is to solve at least the problems and disadvantages of the background art.

It is an object of the present invention to provide an emphasis circuit which can compensate for attenuating signals by applying an emphasis effect to the edges of square wave input signals, and adjust the magnitue as well as the falling time and rising time of the added emphasis signals.

An emphasis circuit according to the present invention adds an emphasis signal to a square wave to compensate for the attenuation of square wave signal, when the square wave signal including the emphasis signal is characterized by a wave form that maintains the original voltage level of the square wave after a predetermined falling time from a rising edge or after a predetermined rising time from a falling edge.

The emphasis circuit according to an embodiment of the present invention can compensate for the attenuating signals by applying an emphasis effect to the edges of square wave input signals, and adjust the magnitue as well as the falling time and rising time of the added emphasis signals.

## BRIEF DESCRIPTION OF THE DRAWINGS

The present invention will be described in detail with reference to the following drawings in which like numerals refer to like elements.

FIG. 1 shows the signals that have been input and output through a conventional transmission line.

FIG. 2 shows the wave form of the input and output signals of an emphasis circuit in accordance with an embodiment of the present invention.

FIG. 3 shows the adjusted parts of the output wave form from an emphasis circuit in accordance with an embodiment of the present invention.

FIG. 4 shows schematically the output wave form of an emphasis circuit in accordance with an embodiment of the present invention.

FIG. 5 shows a configuration of a basic emphasis circuit in accordance with an embodiment of the present invention.

FIG. 6 shows an emphasis circuit in accordance with an embodiment of the present invention.

## DETAILED DESCRIPTION OF PREFERRED EMBODIMENTS

Preferred embodiments of the present invention will be described in a more detailed manner with reference to the drawings.

FIG. 2 shows the wave form of the input and output signals of an emphasis circuit in accordance with an embodiment of the present invention. As illustrated in FIG. 2, to improve the edges of a square wave, the emphasis circuit (22) maintains the voltage level and amplitude magnitue of the square wave signal (20) that is input to the emphasis circuit (22), and an emphasis signal (21) is added to the edges of said square wave signal (20). Then, the square wave signal (20) to which the emphasis circuit (21) is added has a wave form that maintains the original voltage level of the square wave (20) after a predetermined falling time from a rising edge or after a predetermined rising time from a falling edge.

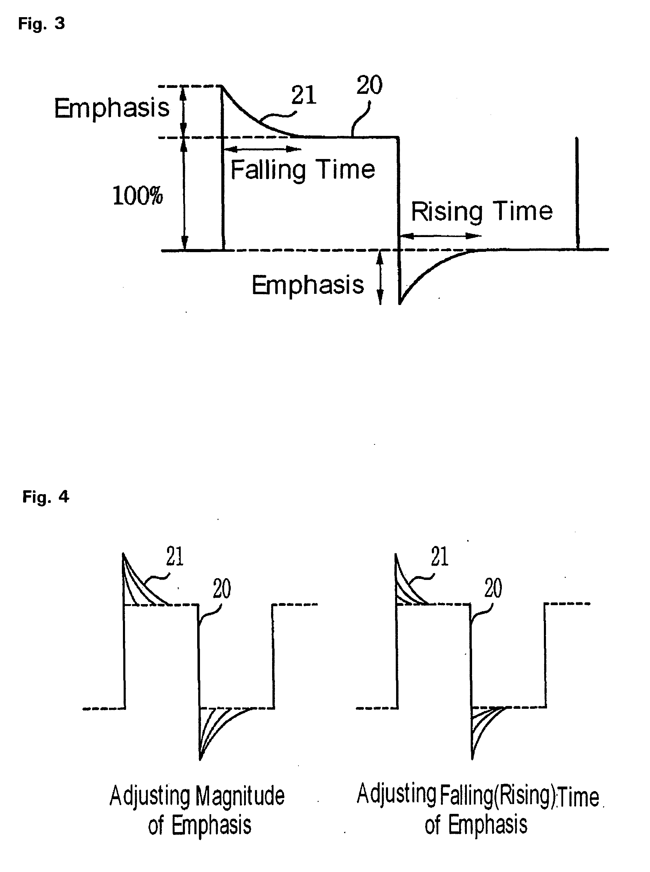

FIG. 3 shows the adjusted parts of the output wave form from an emphasis circuit in accordance with an embodiment of the present invention. As illustrated in FIG. 3, the square wave signal (20) to which the above emphasis signal (21) is added has a wave form that has a higher voltage level than that of the above square wave form signal (20) at the rising edge by the rising emphasis value, and returns to the voltage level of the above square wave signal (20) after a predetermined falling time from the above rising edge.

In addition, the square wave signal (20) to which said emphasis signal (21) is added has a wave form that has a higher voltage level than that of said square wave form signal (20) at the falling edge by the falling emphasis value, and returns to the voltage level of said square wave signal (20) after a predetermined rising time from said falling edge.

Here, the magnitue of the emphasis signal (21) is the magnitue of the emphasis signal (21) less the magnitue of the square wave signal (20). Furthermore, the falling time of said emphasis signal (21) represents the interval during which the wave form of the emphasis signal (21) falls down to the voltage level of the square wave signal (20), while the rising time of said emphasis signal (21) represents the interval during which the wave form of the emphasis signal (21) rises up to the voltage level of the square wave signal (20).

One embodiment of the present invention has a means to adjust the magnitue as well as the falling time and rising time of said emphasis signal (21). This will be described in more detail later.

FIG. 4 shows schematically the output wave form of an emphasis circuit in accordance with an embodiment of the present invention. As illustrated in FIG. 4, said emphasis circuit can adjust the magnitude of the emphasis signal (21) that is added to the edge. In addition, by adjusting the falling time and rising time, it can adjust the time which it takes to return from the voltage level of the emphasis signal (21) to that of the original square wave signal (20).

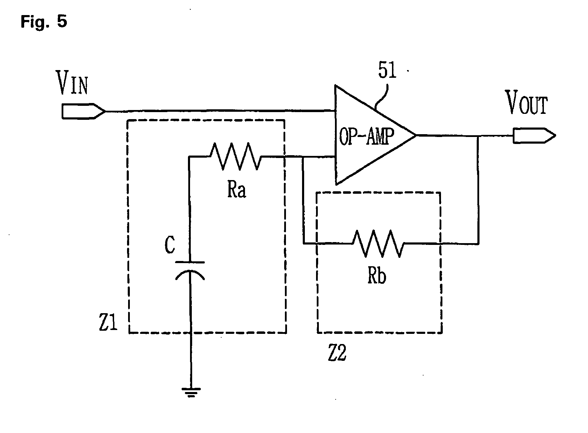

FIG. 5 shows a configuration of a basic emphasis circuit in accordance with an embodiment of the present invention. As illustrated in FIG. 5, what is required when adding an emphasis effect is to maintain the voltage level of the square wave signal. In other words, its high level and low level values must be equal to those of the input signal, except that an emphasis signal of the desired magnitue is added to the edges and the falling time or rising time from the emphasis signal is adjusted.

To meet the above conditions, the emphasis circuit according to an embodiment of the present invention can be configured using an operation amplifier (OP-AMP, 51), and also including a square wave signal Vin which is input through the non-reverse (+) terminal of the OP-AMP (51), a resistance Ra connected to the reserve (-) terminal of the OP-AMP (51), a capacitor C of which one end is serially connected to the above resistance Ra and the other end is grounded, and a resistance Rb that is serially connected to the non-reverse (+) terminal of the OP-AMP (51) and the output terminal (Vout). In this way, the OP-AMP (51) outputs the square wave signal Vin that is input through the non-reverse (+) terminal after amplifying it according to the value corrected by the above C, Ra and Rb values.

The input and output transmission characteristics of the above emphasis circuit configured with the OP-AMP (51) can be expressed as a Laplace Transform formula, which is shown in [Math Formula 1] below:

[Math Formula 1]

$$\frac{Out}{in} = 1 + \frac{Z2}{Z1} = 1 + \frac{Rb}{Ra + 1/SC} = (1 + \frac{Rb}{Ra})(\frac{S + 1/(Ra+Rb)C}{S + 1/RaC})$$

In addition, Math Formula 1 has a pole and zero points as shown in Math Formula 2 and Math Formula 3 respectively below:

[Math Formula 2]

$$Pole = \frac{1}{RaC}$$

[Math Formula 3]

$$Zero = \frac{1}{(Ra+Rb)C}$$

In this case, the phases of frequencies in Math Formulas 2 and 3 can be analyzed as follows:

First, assuming that the value of the capacitor C is fixed, the positions of the pole and zero points are determined relative to the value of Rb. Since the Rb value is always greater than 0, the pole point is located at a higher frequency than the zero point. Therefore, only the frequencies between the pole and zero points have a phase ahead of other frequencies. This effect allows an emphasis signal with a high frequency to be added.

Furthermore, by changing the value of C, we can push ahead the phase of a desired frequency bandwidth. In this case, only the positions of frequencies are changed while the difference between frequencies of the pole and zero points is maintained.

In addition, the falling time and rising time of the emphasis signal are determined depending on the Ra and C values.

Next, when we analyze the gain of frequencies from the Math Formula 1 above, the high frequency gain can be expressed as Math Formula 4 below and the voltage gain as Math Formula 5 below:

[Math Formula 4]

$$HF|Gain=1+\frac{Rb}{Ra}$$

[Math Formula 5]

$$DC|Gain=(1+\frac{Rb}{Ra})(\frac{Ra}{Ra+Rb})=1$$

Assuming that the magnitue of the input square wave signal in Math Formula 4 is 1, the high frequency gain is determined depending on the ratio of Rb value versus Ra value. When the voltage level and amplitude magnitue of the input square wave signal are maintained, said high frequency element is the emphasis signal that is added to the edge. For the high frequency gain, an emphasis signal in accordance with the ratio of the Rb and Ra values is added to the magnitue 1 of the square wave signal. Ideally, Ra value must be greater than Rb value so that the magnitue of the emphasis signal would not exceed the magnitue of the square signal value which is 1.

In Math Formula 5, the gain at the returned voltage level from the emphasis signal that has been added to the edge becomes said voltage gain 1. Thus, the voltage level and amplitude of the input square wave signal are maintained.

As explained above, the magnitue of the added emphasis signal can be adjusted by the values of the resistances Rb and Ra. In particular, the emphasis signal has a magnitue at which the ratio of the above resistance values is proportionate to the magnitue of the input square wave signal. Therefore, we can appropriately apply it in response to the magnitue of the input square wave signal.

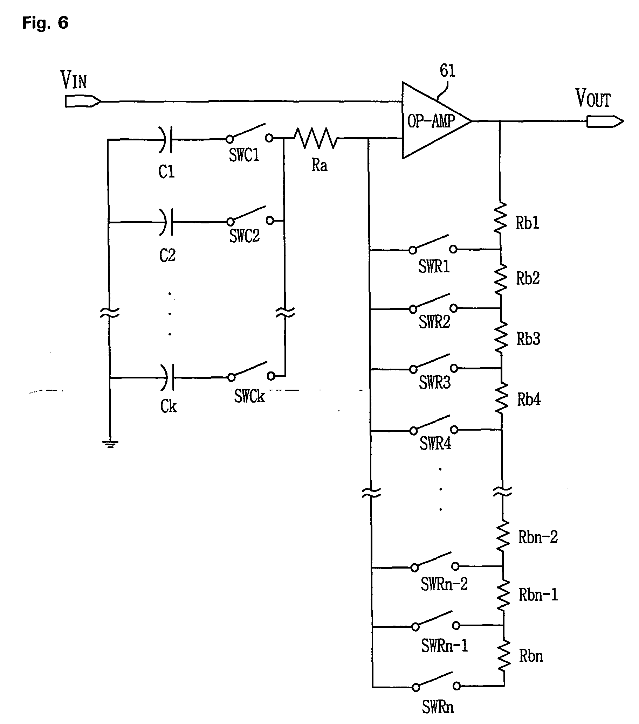

FIG. 6 shows the emphasis circuit in accordance with an embodiment of the present invention. As illustrated in FIG. 6, we can configure a circuit that has a means to adjust the magnitue as well as the falling time and rising time of the emphasis signal by transforming the basic emphasis circuit in FIG. 5.

To meet the above conditions, an emphasis circuit according to an embodiment of the present invention can be configured using an operation amplifier (OP-AMP, 61), and also including a square wave signal Vin which is input through the non-reverse (+) terminal of the OP-AMP (61), a resistance Ra connected to the reserve (-) terminal of the OP-AMP (61), and k units of capacitor C, connected in parallel, of which one end is grounded and the other end is serially connected to a switch SWC that is serially connected to the resistance Ra.

In addition, the above configuration includes n units of switch SWR which are serially connected to the non-reverse (-) terminal of the OP-AMP (61), and n units of resistance Rb which are serially connected to the non-reverse (-) terminal of the OP-AMP (61) and the output terminal (Vout) and also connected in parallel to the n-1 switch SWRn-1.

In FIG. 6, the k units of capacitor C and n units of resistance Rb should have the same capacitor value and the same resistance value, respectively. Thus, when said switch is selectively turned on, the capacitor and resistance values linearly increase or decrease. That is, $C1 = C2 = C3 = ... = Ck$, and $Rb1 = Rb2 = Rb3 = ... = Rbn$.

In the above emphasis circuit, the capacitors can select one value C when one SWC is turned on, and k multiples of C value when k units of SWC are turned on. Furthermore, the resistance should select only one of the n units of SWR. It can select one Rb value when SWR1 is turned on, and n multiples of Rb value when SWRn is turned on.

On the other hand, the input and output transmission characteristics of the emphasis circuit in FIG. 6 can be expressed as a Laplace Transform formula, which is shown in [Math Formula 6] below. In the following Math Formula 6, we will assume that k units of SWC and SWRn among the SWR switches are turned on.

[Math Formula 6]

$$\frac{Out}{in} = 1 + \frac{n*Rb}{Ra+1/(k*SC)} = (1+\frac{n*Rb}{Ra})(\frac{S+1/(Ra+n*Rb)(k*C)}{S+1/Ra(k*C)})$$

Here, we can select a desired frequency element using the switch SWC and a desired magnitue of emphasis signal using the switch SWR. The transmission characteristic formula for FIG. 6 can be expressed as follows:

In a modified embodiment of the present invention, we can decrease or increase the adjustment range of the magnitue and falling time of the emphasis signal. In other words, according to various application, we can implement appropriate emphasis signals by changing the value of the resistance Ra in the above emphasis circuit.

On the other hand, this emphasis circuit can be embodied using integrated circuits or individual devices.

The invention being thus described, it will be obvious that the same may be varied in many ways. Such variations are not to be regarded as a departure from the spirit and scope of the invention, and all such modifications as would be obvious to one skilled in the art are intended to be included within the scope of the following claims.

The claims refer to examples of preferred embodiments of the invention. However, the invention also refers to the use of any single feature and subcombination of features which are disclosed in the claims, the description and / or the drawings.

## Claims

1. An emphasis circuit adding an emphasis signal to a square wave to compensate for the attenuation of square wave signal,

   wherein the square wave signal including the emphasis signal is **characterized by** a wave form maintaining the original voltage level of the square wave after a predetermined falling time from a rising edge or after a predetermined rising time from a falling edge.

2. The emphasis circuit of claim 1,

   wherein the square wave signal including the emphasis signal is **characterized by** a wave form having a higher voltage level than the voltage level of the square wave signal by the rising emphasis value in the rising edge, and returns to the voltage level of the square wave signal after a predetermined falling time from the rising edge;

   and having a lower voltage level than the voltage level of the square wave signal by the falling emphasis value in the falling edge, and returns to the voltage level of the square wave signal after a predetermined rising time from the falling edge.

3. An emphasis circuit adding an emphasis signal to a square wave to compensate for the attenuation of square wave signal, comprising;

   a signal control means for adjusting the magnitude of the emphasis signal; and
   a time control means for adjusting the falling time and rising time of the emphasis signal.

4. The emphasis circuit of claim 3, further comprising a selection means for selecting an adjustment range of the magnitude, falling time and rising time of the emphasis signal.

5. The emphasis circuit of claim 3, wherein the signal control means comprises one or more resistances.

6. The emphasis circuit of claim 3, wherein the time control means comprises one or more resistances and capacitances.

7.   The emphasis circuit of claim 4, wherein the selection means comprises a frequency selecting means and a signal magnitude selecting means.

8.   The emphasis circuit of claim 6, wherein the time control means comprises a plurality of capacitances.

**Fig. 1**

**Fig. 2**

Emphasis Circuit

100%

100%

Fig. 3

Fig. 4

Adjusting Magnitude
of Emphasis

Adjusting Falling(Rising)Time
of Emphasis

**Fig. 5**

**Fig. 6**

**European Patent Office**

**EUROPEAN SEARCH REPORT**

Application Number

EP 05 00 1251

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | PATENT ABSTRACTS OF JAPAN vol. 013, no. 288 (E-781), 30 June 1989 (1989-06-30) & JP 01 071309 A (SONY CORP), 16 March 1989 (1989-03-16) * abstract * | 1-8 | H04B1/62 H04L25/03 H03G7/08 |
| X | PATENT ABSTRACTS OF JAPAN vol. 009, no. 035 (E-296), 14 February 1985 (1985-02-14) & JP 59 178810 A (FUJITSU KK), 11 October 1984 (1984-10-11) * abstract * | 1-8 | |
| X | PATENT ABSTRACTS OF JAPAN vol. 011, no. 104 (E-494), 2 April 1987 (1987-04-02) & JP 61 252721 A (NEC CORP), 10 November 1986 (1986-11-10) * abstract * | 1-8 | |
| X | PATENT ABSTRACTS OF JAPAN vol. 007, no. 111 (E-175), 14 May 1983 (1983-05-14) & JP 58 031674 A (ROOMU KK), 24 February 1983 (1983-02-24) * abstract * | 1-8 | TECHNICAL FIELDS SEARCHED (Int.Cl.7) H04B H04L H03G |
| X | PATENT ABSTRACTS OF JAPAN vol. 1999, no. 02, 26 February 1999 (1999-02-26) & JP 10 294630 A (SANYO ELECTRIC CO LTD), 4 November 1998 (1998-11-04) * abstract * | 1-8 | |

The present search report has been drawn up for all claims

| Place of search | Date of completion of the search | Examiner |
|---|---|---|
| Munich | 31 May 2005 | Santos, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
 
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 05 00 1251

This annex lists the patent family members relating to the patent documents cited in the above-mentioned European search report.
The members are as contained in the European Patent Office EDP file on
The European Patent Office is in no way liable for these particulars which are merely given for the purpose of information.

31-05-2005

| Patent document cited in search report | | Publication date | Patent family member(s) | | Publication date |
|---|---|---|---|---|---|
| JP 01071309 | A | 16-03-1989 | NONE | | |
| JP 59178810 | A | 11-10-1984 | NONE | | |
| JP 61252721 | A | 10-11-1986 | NONE | | |
| JP 58031674 | A | 24-02-1983 | NONE | | |
| JP 10294630 | A | 04-11-1998 | JP | 3234531 B2 | 04-12-2001 |